# FASCICULE DE BREVET EUROPEEN

(11) **EP 0 718 850 B1**
(45) Date de publication et mention de la délivrance du brevet: **25.02.1998**
(21) Numéro de dépôt: 95402815.5
(22) Date de dépôt: 14.12.1995
(51) Int. Cl.: G11C 29/00

(54) **Procédé et circuit de test pour mémoire en circuit intégré**
Verfahren und Schaltung zum Testen von integriertem Speicher
Integrated circuit memory test method and circuit

(30) Priorité: 21.12.1994 FR 9415430
(43) Date de publication de la demande: 26.06.1996
(73) Titulaire: SGS-THOMSON MICROELECTRONICS S.A., 94250 Gentilly (FR)
(72) Inventeur: Mirabel, Jean-Michel, F-94230 Cachan (FR); Yero, Emilio, F-94230 Cachan (FR)
(74) Mandataire: Schmit, Christian Norbert Marie

(56) Documents cités:
- EP-A- 0 462 876
- US-A- 5 361 232

## Description

L'invention concerne le test des mémoires réalisées en circuit intégré. L'invention s'applique tout particulièrement, mais pas exclusivement, aux mémoires électriquement programmables, dont la cellule de base est un transistor à grille flottante (EPROM, E²PROM, flash EPROM).

Caractériser une cellule mémoire, c'est relever sa courbe i=f(v). Pour cela on utilise un mode d'accès particulier à la cellule dit à accès direct.

On rappelle que les cellules des mémoires en circuit intégré sont agencées matriciellement. Une ligne de mot commande (directement ou par l'intermédiaire de transistors de sélection) les grilles des cellules situées sur une même rangée. L'état d'une cellule est lu sur une ligne de bit reliée aux drains des cellules situées avec cette cellule sur une même colonne.

Quand on veut lire une cellule, on fournit son adresse à un décodeur de la mémoire qui sélectionne la ligne de mot correspondante pour appliquer une tension de lecture sur la grille de la cellule et qui sélectionne la ligne de bit correspondante pour la connecter à un dispositif de précharge et lecture.

Ce dispositif de précharge et de lecture comprend classiquement un convertisseur courant-tension qui fournit en sortie un niveau de tension variant fortement avec le courant d'entrée. De manière simplifiée, si la cellule est faiblement passante, la tension en sortie du convertisseur sera grande. Si la cellule est fortement passante, cette tension de sortie sera faible. Cette tension de sortie est appliquée à un circuit de lecture comprenant par exemple un amplificateur différentiel, qui fournit l'information binaire. Le doucument IEEE Journal of Solid-State Circuits, Vol SC-22, n° 4, August 1987, pages 548-552 ayant pour titre "A 256-Kbit Flash EEPROM Using Triple-Polysilicon Technology" décrit un exemple de convertisseur courant-tension pour la lecture de cellules mémoires.
Le dispositif de précharge et lecture comprend aussi un élément de précharge (résistance ou transistor) qui est activé dès la détection d'un changement d'adresse pour injecter du courant dans le convertisseur courant-tension qui asservit ainsi la ligne de bit (capacitive) à une tension de précharge. De cette manière, on accélère le temps d'accès en lecture.

Pour caractériser une cellule mémoire, on doit isoler cette cellule des éléments auxquels elle est normalement reliée, pour éviter toute perturbation extérieure. On isole ainsi le dispositif de précharge et lecture pour imposer directement une tension de test variable sur la ligne de bit. On relève le courant correspondant sur cette ligne. Pour cela on prévoit généralement un circuit pour inhiber le dispositif de précharge et lecture en test. Quand ce circuit est activé, si on adresse la cellule en lecture (signaux d'adresse, sélection de la mémoire, commande de lecture), on peut lire directement le courant sur la ligne de bit, fonction de la tension de test que l'on y applique. On obtient une caractéristique i=f(v) fonction des paramètres intrinsèques à la cellule, qui permet de détecter des faiblesses éventuelles et le cas échéant, de mettre au rebut la mémoire. On peut appliquer la tension de test et relever le courant au moyen d'une sonde appliquée sur un point de test de la ligne de bit. On préfère prévoir au moins un transistor de court-circuit du dispositif de précharge et lecture pour relier directement la ligne de bit à un plot d'accès de la mémoire. Ainsi, on applique la tension de test et on relève le courant, directement sur la broche d'entrée/sortie associée au dispositif de précharge et lecture en test. Le document EP-A-0 462 876 montre ainsi un circuit de test comprenant un transistor pour inhiber un dispositif de précharge.

En pratique, cette caractérisation s'est révélée insuffisante à prévenir certaines défaillances de mémoires.

Un objet de l'invention est d'améliorer le test des cellules mémoires.

On s'est en effet rendu compte que le procédé de test ne tenait pas compte des variations technologiques dues au procédé de fabrication.

Or, en lecture, une cellule mémoire est polarisée dans la zone de fonctionnement linéaire (par exemple, pour une cellule de mémoire flash EPROM, on met environ 5 volts sur sa grille et 1 volt sur son drain). Dans cette zone de fonctionnement, une petite variation de la tension de drain (sur la ligne de bit) entraîne une grande variation de courant.

Cette tension de drain est imposée par le dispositif de précharge et lecture, et plus particulièrement par le convertisseur courant-tension. Les caractéristiques d'asservissement du convertisseur ne sont cependant pas exactement définies, du fait des variations technologiques intrinsèques au procédé de fabrication de la mémoire en circuit intégré. Or, si la tension de drain est par exemple un peu plus élevée, il passera plus de courant dans la cellule et sur la ligne de bit, ce qui au terme d'accès en lecture répétés, pourrait endommager les cellules, réduisant la durée de vie de la mémoire.

Les variations technologiques peuvent aussi influer sur la réponse en courant de l'élément de précharge.

Un objet de l'invention est une mémoire en circuit intégré avec un dispositif de précharge et lecture qui comprend un circuit de test pour prendre en compte ces différents facteurs, pouvant influer sur le comportement opérationnel d'une cellule mémoire.

Telle qu'elle est caractérisée, l'invention concerne une mémoire en circuit intégré organisée matriciellement en lignes et colonnes et comportant au moins un dispositif de précharge et lecture associé à une ou plusieurs lignes, ledit dispositif comprenant un élément de précharge, un convertisseur courant-tension et un circuit de lecture, la sélection d'une ligne associée activant l'élément de précharge et connectant l'entrée dudit convertisseur à ladite ligne, la sortie dudit convertisseur étant connectée à l'élément de précharge et à l'entrée du circuit de lecture.

Selon l'invention, le dispositif de précharge et lecture comprend en outre un circuit de test pour mettre hors circuit le circuit de lecture, appliquer une tension de test sur la sortie dudit convertisseur et mesurer un courant sur cette sortie.

Un autre objet de l'invention est un procédé de mesure du courant d'une cellule d'une mémoire en circuit intégré comprenant un dispositif de précharge et de lecture de ladite cellule mémoire, ledit dispositif comportant un élément de précharge, un convertisseur courant-tension et un circuit de lecture, la sélection de ladite cellule activant l'élément de précharge et connectant l'entrée dudit convertisseur à ladite ligne, la sortie dudit convertisseur étant connectée à l'élément de précharge et à l'entrée du circuit de lecture. Selon ce procédé, la sortie dudit convertisseur est utilisée pour appliquer une tension de test et pour y effectuer ladite mesure de courant, tandis que l'élément de précharge et le circuit de lecture sont forcés à l'état inactif.

Avantageusement, on prévoit en outre de relever la caractéristique courant-tension de l'élément de précharge seul.

D'autres caractéristiques et avantages de l'invention sont présentés dans la description suivante, faite à titre indicatif et non limitatif, de l'invention, en référence aux dessins annexés, dans lesquels :
- la figure 1 représente un exemple d'architecture d'une mémoire en circuit intégré,
- la figure 2 représente un dispositif de précharge et de lecture associé à une ligne de bit d'une mémoire en circuit intégré et un circuit de test selon l'état de la technique et
- la figure 3 représente un dispositif de précharge et lecture comprenant un circuit de test selon l'invention.

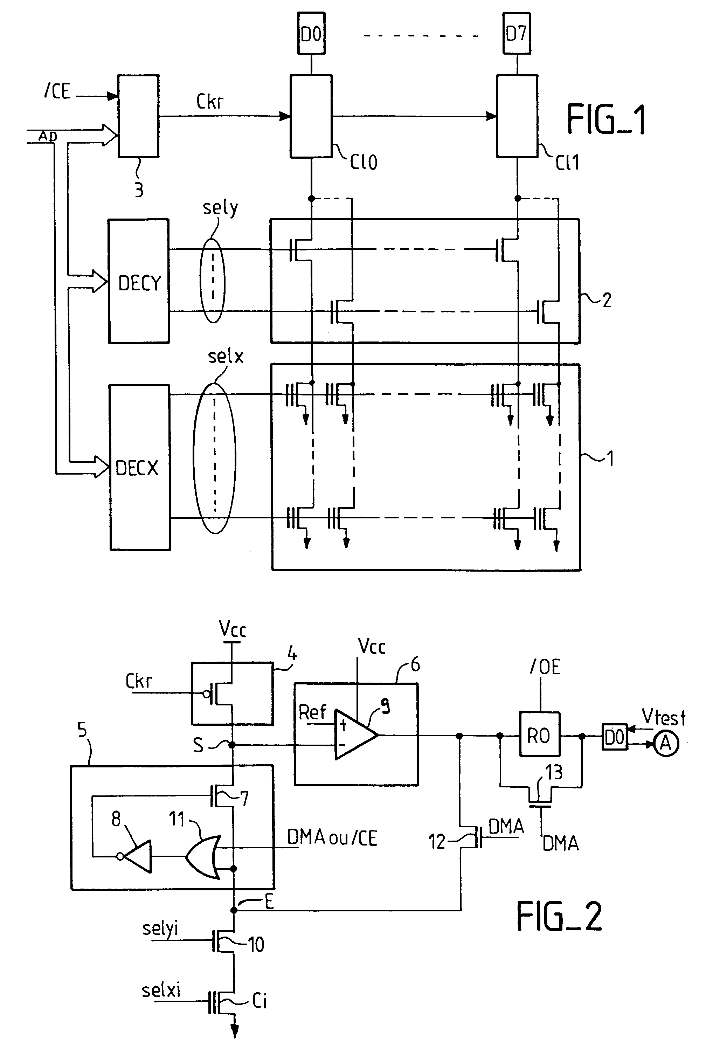

Sur la figure 1, on a représenté un plan de cellules mémoires 1 agencé matriciellement en lignes de bit et lignes de mot, un circuit porte 2 commandé par un décodeur de ligne de bit (DECY) pour sélectionner (sely) une ou plusieurs lignes de bit (8 dans l'exemple) et les relier chacune à un dispositif de précharge et lecture associé (C10, ..., C17).

Le plan mémoire est par ailleurs contrôlé par un décodeur de lignes de mot (DECX) pour sélectionner (selx) une ligne de mot.

Un circuit de détection de transitions d'adresse 3 qui reçoit les signaux de sélection de la mémoire /CE, et du bus d'adresse AD, fournit un signal de déclenchement Ckr des dispositifs de précharge et lecture (C10, ..., C17), dès la détection d'une nouvelle adresse.

Un dispositif de précharge et lecture est détaillé à la figure 2. Il comprend un élément de précharge 4 connecté entre la tension d'alimentation logique Vcc et la sortie S d'un convertisseur courant-tension 5 et un circuit de lecture 6 connecté en sortie S du convertisseur pour délivrer un signal binaire sur un registre de sortie R0 associé à une broche d'entrée/sortie D0 de la mémoire en circuit intégré.

L'élément de précharge 4 comprend de manière classique un élément résistif. Dans l'exemple simple représenté, l'élément de précharge est un transistor MOS de type P, dont la source est reliée à la tension d'alimentation logique Vcc et le drain à la sortie S du convertisseur. Il est mis à l'état passant par le signal de déclenchement Ckr, appliqué dans l'exemple directement sur sa grille.

Le convertisseur courant-tension 5 comprend classiquement un transistor 7 connecté en série entre l'entrée E et la sortie S du convertisseur, et un inverseur 8 entre l'entrée du convertisseur et la grille du transistor 7. Ce montage simple constitue un asservissement établissant sur l'entrée du convertisseur une tension de précharge liée aux caractéristiques technologiques du transistor 7 et de l'inverseur 8. Dans l'exemple représenté, le transistor 7 est un transistor MOS de type N, ayant sa source connectée à l'entrée E et son drain connecté à la sortie S.

Le circuit de lecture 6 comprend typiquement un circuit 9 de type comparateur à une valeur de référence ref. Il peut comprendre à la suite du comparateur, amplificateurs ou inverseurs (non représentés).

Le circuit de lecture 6 est généralement connecté en sortie à un registre de sortie 3 états RO associé à la broche d'entrée D0 : un état inactif (1) d'un signal de validation de sortie /OE force la sortie du registre en haute impédance. Un état actif (0) transmet l'information logique en sortie du circuit de lecture sur la broche D0.

L'entrée E du convertisseur est activement connectée à une ligne de bit sélectionnée par un transistor 10 du circuit porte 2 de la figure 1, commandé par un signal selyi du décodeur de lignes de bit DECY (figure 1). Les autres lignes de bit éventuellement connectées à cette même entrée E sont nécessairement désélectionnées.

Une cellule Ci de la ligne de bit sélectionnée en lecture (selxi), a une tension de lecture correspondante appliquée sur sa grille (de l'ordre de 5 volts pour une cellule flash EPROM).

Quand la cellule est adressée en lecture, elle est sélectionnée et le signal de déclenchement Ckr est généré : le circuit de précharge fournit un courant d'injection vers le convertisseur courant-tension qui asservit la ligne de bit sélectionnée (li) à une tension de précharge. La cellule Ci fournit un certain courant, fonction de son état programmé ou non, qui fait réagir le convertisseur. Une tension s'établit en sortie du convertisseur, comparée à la référence par le comparateur qui fournit en sortie l'information binaire 0 ou 1 correspondante. Cette information binaire est transmise sur la broche D0 par activation du signal de validation de sortie /OE.

Selon l'état de la technique et comme représenté sur la figure 2, pour relever la courbe i=f(v) d'une cellule, on met habituellement hors-circuit le dispositif de précharge et lecture. Pour cela, il est en général prévu une porte logique devant l'inverseur 8 du convertisseur courant-tension. Dans l'exemple de la figure 2, le transistor 7 du convertisseur courant-tension étant de type N, il faut forcer sa grille à zéro pour le bloquer. Dans ce cas, la porte logique est une porte OU 11 qui reçoit en entrée un signal de test DMA, et l'entrée E du convertisseur. L'activation du signal de test DMA (à 1) force le transistor 7 du convertisseur à l'état bloqué, isolant ainsi l'entrée de la sortie du convertisseur (figure 2). Comme signal de test DMA, on utilise généralement le signal de sélection de la mémoire /CE que l'on force à 1.

Pour utiliser la broche d'entrée/sortie associée au dispositif de précharge et lecture comme borne de test, un transistor 12 pour court-circuiter le dispositif de précharge et lecture en mode de test est prévu. En pratique, un deuxième transistor de court-circuit est utilisé pour court-circuiter le registre de sortie associé R0. On peut utiliser un seul transistor pour court-circuiter l'ensemble dispositif de précharge et lecture et registre de sortie, mais l'utilisation des deux transistors de court-circuit 12 et 13 est avantageuse. En effet, le dispositif de précharge et lecture est en général placé près des cellules mémoires, situées topologiquement au centre du circuit intégré, tandis que le registre de sortie sera plutôt situé en périphérie, près des broches d'entrée/sortie. Comme il n'est pas souhaitable de multiplier les longues connexions, il vaut mieux court-circuiter localement les différents éléments.

Enfin, pour le test, le signal de validation de sortie /OE est mis à l'état haut, pour forcer la sortie du registre de sortie R0 en haute impédance.

On peut alors appliquer directement une tension de test (variable) Vtest sur la broche d'entrée/sortie et y relever le courant.

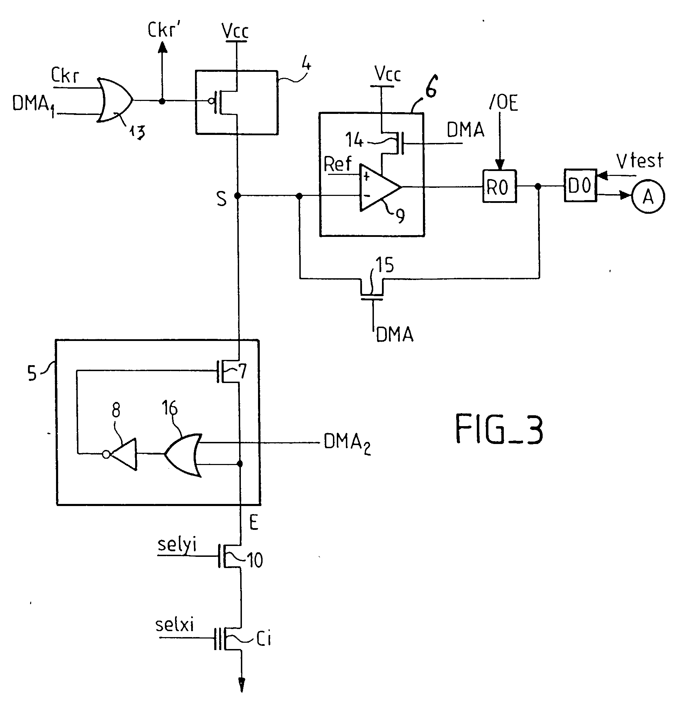

Selon l'invention et comme représenté sur la figure 3, au lieu d'être globalement court-circuité, un circuit de test est prévu qui permet d'appliquer une tension de test sur la sortie S du convertisseur et d'y relever le courant, en mettant hors-circuit l'élément de précharge et le circuit de lecture.

Dans l'exemple de la figure 3, le circuit de test comprend ainsi une porte logique 13 pour forcer à l'état inactif (0 en l'occurrence) le signal de déclenchement Ckr appliqué à l'élément de précharge 4. Dans l'exemple, il s'agit d'une porte OU qui reçoit un premier signal de test DMA₁ et le signal de déclenchement Ckr et qui délivre un signal de déclenchement validé du dispositif de précharge et lecture, noté Ckr'. On notera qu'une seule porte logique est suffisante pour l'ensemble de la mémoire : le signal Ckr' est appliqué à tous les dispositifs de précharge.

Le circuit de test comprend aussi un transistor 14 pour mettre hors circuit le circuit de lecture 6.

Le transistor 14 est par exemple connecté entre l'alimentation logique Vcc et le circuit de lecture, et commandé par un signal de test noté DMA sur la figure. De préférence, pour utiliser la broche d'entrée/sortie DO comme borne de test, on prévoit un transistor 15 connecté entre la sortie S du convertisseur et la broche D0 et commandé par le même signal de test DMA. A la place du transistor 15 représenté sur la figure 3, on peut prévoir un premier transistor en parallèle sur le circuit de lecture et un deuxième en parallèle sur le registre de sortie associé, comme déjà expliqué en relation avec la figure 2.

Selon l'invention, le procédé de mesure de courant consiste :
- à adresser la cellule mémoire Ci, ce qui génère le signal de déclenchement Ckr, et sélectionne la cellule (selxi, selyi),
- à appliquer les signaux de test pour inhiber l'élément de précharge (DMA₁) et le circuit de lecture (DMA),
- à appliquer la tension de test (Vtest) sur la sortie 5 du convertisseur et à y mesurer le courant.

Dans le cas préféré où on utilise la broche d'entrée/sortie D0 pour appliquer la tension de test et mesurer le courant, on maintient le signal de validation de sortie /OE à l'état inactif (1) pour mettre la sortie du registre de sortie en haute impédance et l'on utilise le signal de test DMA pour court-circuiter le circuit de lecture (6) et le registre de sortie (R0).

Le signal de test DMA pour inhiber le circuit de lecture, voire le court-circuiter, et le signal de test DMA₁ pour inhiber l'élément de précharge, sont de préférence différents pour pouvoir mesurer le courant de l'élément de précharge en fonction d'une tension de test appliquée comme précédemment. Le circuit de test comprend alors en outre une porte logique 16 pour imposer une tension de blocage sur la grille du transistor du convertisseur.

Par exemple, on place une porte OU 16 devant l'inverseur 8 du convertisseur, cette porte OU recevant l'entrée du convertisseur et un signal de test DMA₂ qui sera forcé dans l'exemple à 1 pendant le test de l'élément de précharge.

Avec ce perfectionnement, on peut effectuer un premier test en activant les signaux de test DMA et DMA₁ pour mesurer le courant de la cellule mémoire sélectionnée et polarisée via le convertisseur et un deuxième test en activant les signaux DMA et DMA₂ pour mesurer le courant de l'élément de précharge seul.

Les signaux de test DMA, DMA₁ et DMA₂ sont appliqués par des sondes ; l'un au moins peut être commandé par la broche de sélection de la mémoire (/CE), par exemple le signal DMA qui est utilisé dans les deux tests.

On peut alors connaître le comportement vrai de chaque cellule de la mémoire en circuit intégré, ce qui permet d'augmenter la fiabilité de la mémoire, en autorisant un procédé de test plus approfondi.

## Revendications

1. Mémoire en circuit intégré, organisée matriciellement en lignes et colonnes et comportant au moins un dispositif de précharge et lecture (4-6) associé à une ou plusieurs lignes, ledit dispositif comprenant un élément de précharge (4), un convertisseur courant-tension (5) et un circuit de lecture (6), la sélection d'une ligne associée (li) activant l'élément de précharge (4) et connectant l'entrée (E) dudit convertisseur (5) à ladite ligne, la sortie (S) dudit convertisseur (5) étant connectée à l'élément de précharge (4) et à l'entrée du circuit de lecture (6),
mémoire caractérisée en ce qu'elle comprend en outre un circuit de test (13-16) pour mettre hors-circuit l'élément de précharge (4) et le circuit de lecture (6), appliquer une tension de test (Vtest) sur la sortie (S) dudit convertisseur (5) et mesurer un courant sur cette sortie (S).

2. Mémoire selon la revendication 1, caractérisée en ce que le circuit de test (13-16) comprend un premier transistor (14) commandé par un signal de test (DMA) pour couper l'alimentation logique (Vcc) du circuit de lecture (6).

3. Mémoire selon la revendication 1, caractérisée en ce que le circuit de test (13-16) comprend une porte logique (13) recevant un signal de test (DMA₁) pour forcer l'élément de précharge (4) à l'état inactif.

4. Mémoire selon la revendication 1 ou 2, caractérisée en ce que le circuit de test (13-16) comprend en outre une autre porte logique (16) commandée par un signal de test (DMA₂) pour isoler l'entrée (E) du convertisseur (5) de sa sortie (S), le circuit de test (13-16) permettant alors en inhibant le circuit de lecture (6), d'appliquer une tension de test (Vtest) sur la sortie (S) du convertisseur (5) et d'y mesurer le courant issu de l'élément de précharge (4).

5. Mémoire selon la revendication 2, le dispositif de précharge (4) étant connecté à une broche d'entrée/sortie (D0) de la mémoire, caractérisée en ce que le circuit de test (13-16) comprend en outre au moins un transistor (15) connecté entre la sortie (S) du convertisseur (5) et ladite broche et commandé par le signal de test (DMA) appliqué au transistor (14) pour couper l'alimentation du circuit de lecture (6), pour appliquer la tension de test sur ladite broche d'entrée/sortie (D0) et y mesurer le courant.

6. Procédé de mesure du courant d'une cellule d'une mémoire en circuit intégré comprenant un dispositif de précharge (4) et de lecture (6) de ladite cellule mémoire, ledit dispositif comportant un élément de précharge (4), un convertisseur courant-tension (5) et un circuit de lecture (6), la sélection de ladite cellule activant l'élément de précharge (4) et connectant l'entrée (E) dudit convertisseur (5) à ladite ligne, la sortie (S) dudit convertisseur (5) étant connectée à l'élément de précharge (4) et à l'entrée du circuit de lecture (6),
procédé caractérisé en ce que la sortie (S) dudit convertisseur (5) est utilisée pour appliquer une tension de test (Vtest)et pour y effectuer ladite mesure de courant, tandis que l'élément de précharge (4) et le circuit de lecture (6) sont forcés à l'état inactif.

7. Procédé selon la revendication 6, caractérisé en ce qu'il permet en outre de mesurer le courant dans l'élément de précharge (4) en fonction d'une tension de test appliquée sur la sortie du convertisseur (5), le circuit de lecture (6) étant inactif et l'entrée dudit convertisseur (5) étant isolée de sa sortie.

## Patentansprüche

1. Integrierter Speicher, der aus einer Matrix mit Zeilen und Spalten aufgebaut ist und mindestens eine Vorrichtung zur Vorlast und zum Lesen (4-6) aufweist und an eine oder mehrere Leitungen angeschlossen ist, wobei diese Vorrichtung ein Vorlastelement (4) aufweist, einen Stromspannungswandler (5) und einen Leseschaltkreis (6), wobei die Auswahl einer angeschlossenen Leitung (li), das Vorlastelement (4) aktiviert und den Eingang (E) des Wandlers (5) an diese Leitung anschließt, und der Ausgang (S) dieses Wandlers (5), an das Vorlastelement (4) und an den Eingang des Leseschaltkreises (6) angeschlossen ist,
dadurch gekennzeichnet, daß er darüber hinaus einen Testschaltkreis (13-16) aufweist, der das Vorlastelement (4) und den Leseschaltkreis (6) aus dem Schaltkreis herausschaltet, um eine Testspannung (Vtest) an den Ausgang (S) des Wandlers (5) anzulegen und einen Strom an diesem Ausgang (S) zu messen.

2. Speicher nach Anspruch 1, dadurch gekennzeichnet, daß der Testschaltkreis (13-16) einen ersten Transistor (14) aufweist, der von einem Testsignal (DMA) gesteuert wird, um die logische Versorgung (Vcc) des Leseschaltkreises (6) zu unterbrechen.

3. Speicher nach Anspruch 1, dadurch gekennzeichnet, daß der Testschaltkreis (13-16) einen logischen Anschluß (13) aufweist, der ein Testsignal (DMA₁) für die Inaktivierung des Vorlastelements (4) empfängt.

4. Speicher nach Anspruch 1 oder 2, dadurch gekennzeichnet, daß der Testschaltkreis (13-16) darüber hinaus einen weiteren logischen Anschluß (16) aufweist, der von einem Testsignal (DMA₂) gesteuert wird, um den Eingang (E) des Wandlers (5) von seinem Ausgang (S) zu isolieren, der Testschaltkreis (13-16), der es nun möglich macht, daß während der Leseschaltkreis (6) verzögert wird, eine Testspannung (Vtest) an den Ausgang (S) des Wandlers (5) angelegt wird und dort der ausgehende Strom gemessen wird, der aus dem Vorlastelement (4) kommt.

5. Speicher nach Anspruch 2, wobei die Vorlastvorrichtung (4) an einen Ausgangsstift/Anschlußstift (D0) des Speichers angeschlossen ist, dadurch gekennzeichnet, daß der Testspeicher (13-16) darüber hinaus wenigstens einen Transistor (15) aufweist, der zwischen dem Ausgang (S) des Wandlers (5) und dem Stift angeschlossen ist und von einem Testsignal (DMA) gesteuert wird, das an den Transistor (14) angelegt wird, um die Versorgung des Leseschaltkreises (6) abzuschneiden, um die Testspannung an jenen Ausgangs-/Anschlußstift (D0) anzulegen und um dort den Strom zu messen.

6. Meßvorgang, um den Strom einer integrierten Speicherzelle zu messen, wobei diese eine Vorlastvorrichtung (4) und eine Lesevorrichtung (6) dieser Speicherzelle aufweist, die Vorrichtung ein Vorlastelement (4), einen Stromspannungswandler (5) und einen Leseschaltkreis (6) aufweist, wobei die Auswahl dieser Zelle das Vorlastelement (4) aktiviert und den Eingang (E) des Wandlers (5) an die Leitung anschließt, der Ausgang (S) dieses Wandlers (5) an das Vorlastelement (4) und an den Eingang des Leseschaltkreises (6) angeschlossen ist,
ein Vorgang, der dadurch gekennzeichnet ist, daß der Ausgang (S) dieses Wandlers (5) verwendet wird, um eine Testspannung (Vtest) anzulegen und dort die Messung des Stromes auszuführen während dessen das Vorlastelement (4) und der Leseschaltkreis (6) zu einem inaktiven Zustand gezwungen werden.

7. Vorgang nach Anspruch 6, dadurch gekennzeichnet, daß er darüber hinaus erlaubt den Strom im Vorlastelement (4) als Funktion einer Testspannung, die am Ausgang des Wandlers (5) angelegt wird, zu messen, der Leseschaltkreis inaktiv ist und der Eingang dieses Wandlers (5) von seinem Ausgang isoliert ist.

## Claims

1. Integrated circuit memory, organised in a matrix in rows and columns and having at least one precharging and reading device (4-6) associated with one or more lines, the said device comprising a precharging element (4), a current to voltage converter (5) and a reading circuit (6), the selection of an associated line (li) activating the precharging element (4) and connecting the input (E) of the said converter (5) to the said line, the output (S) of the said converter (5) being connected to the precharging element (4) and to the input of the reading circuit (6),
a memory characterised in that it also comprises a test circuit (13-16) for switching off the precharging element (4) and the reading circuit (6), applying a test voltage (Vtest) to the output (S) of the said converter (5) and measuring a current at this output (S).

2. Memory according to Claim 1, characterised in that the test circuit (13-16) comprises a first transistor (14) controlled by a test signal (DMA) in order to cut of the logic supply (Vcc) of the reading circuit (6).

3. Memory according to Claim 1, characterised in that the test circuit (13-16) comprises a logic gate (13) receiving a test signal (DMA₁) in order to force the precharging element (4) to the inactive state.

4. Memory according to Claim 1 or 2, characterised in that the test circuit (13-16) also comprises another logic gate (16) controlled by a test signal (DMA₂) in order to isolate the input (E) of the converter (5) from its output (S), the test circuit (13-16) then making it possible, by inhibiting the reading circuit (6), to apply a test voltage (Vtest) to the output (S) of the converter (5) and to measure thereon the current coming from the precharging element (4).

5. Memory according to Claim 2, the precharging device (4) being connected to an input/output pin (DO) of the memory, characterised in that the test circuit (13-16) also comprises at least one transistor (15) connected between the output (S) of the converter (5) and the said pin and controlled by the test signal (DMA) applied to the transistor (14) in order to cut off the supply to the reading circuit (6), to apply the test voltage to the said input/output pin (DO) and to measure the current thereon.

6. Method of measuring the current of a cell of an integrated circuit memory comprising a device for precharging (4) and reading (6) the said memory cell, the said device having a precharging element (4), a current to voltage converter (5) and a reading circuit (6), the selection of the said cell activating the precharging element (4) and connecting the input (E) of the said converter (5) to the said line, the output (S) of the said converter (5) being connected to the precharging element (4) and to the input of the reading circuit (6),
a method characterised in that the output (S) of the said converter (5) is used for applying a test voltage (Vtest) and for making the said current measurement thereon, whilst the precharging element (4) and the reading circuit (6) are forced to the inactive state.

7. Method according to Claim 6, characterised in that it also makes it possible to measure the current in the precharging element (4) as a function of a test voltage applied to the output of the converter (5), the reading circuit (6) being inactive and the input of the said converter (5) being isolated from its output.
